# NOUVEAU FASCICULE DE BREVET EUROPEEN

(11) **EP 0 570 784 B2**
(45) Date de publication et mention de la décision concernant l'opposition: **01.09.2004**
(45) Mention de la délivrance du brevet: 13.03.1996
(21) Numéro de dépôt: 93107491.8
(22) Date de dépôt: 08.05.1993
(51) Int. Cl.: G06K 19/06

(54) **Carte comprenant au moins un élément électronique, et procédé de fabrication d'une telle carte**
Mindestens einen elektronischen Baustein enthaltende Karte und Verfahren zur Herstellung der Karte
Card with at least one electronic element and process for manufacturing said card

(30) Priorité: 19.05.1992 FR 9206169
(43) Date de publication de la demande: 24.11.1993
(73) Titulaire: NagraID S.A., 2300 La Chaux-de-Fonds (CH)
(72) Inventeur: Droz, François, 2300 La Chaux-de-Fonds (CH)
(74) Mandataire: Surmely, Gérard

(56) Documents cités:
- EP-A- 0 350 179
- EP-B1- 0 267 231
- DE-A1- 2 220 721
- DE-A1- 2 633 164
- DE-C2- 2 659 573
- FR-A- 2 520 541
- US-A- 4 999 742
- Kunststoff-Lexikon Carl Hanser Verlag München Wien, 1981, Seiten 294, 450, 451, 464 bis 465

## Description

La présente invention concerne une carte comprenant au moins un élément électronique, ainsi qu'un procédé de fabrication d'une telle carte.

Plus particulièrement, la présente invention concerne une carte ne présentant aucun contact extérieur.

La carte selon l'invention peut par exemple être utilisée comme carte bancaire, comme carte d'accès à un espace clos, ou encore en association avec un distributeur de marchandises. Une telle carte peut aussi être utilisée comme moyen d'identification ou de contrôle.

On comprend par carte tout objet ayant une structure sensiblement plane définissant un plan général et présentant un contour quelconque dans ce plan général.

Il est connu de l'homme du métier une carte, comprenant des éléments électroniques, formée d'une coque dans laquelle sont prévus des logements, destinés à recevoir ces éléments électroniques, et d'une couche extérieure protectrice qui ferme les logements.

Il est aussi connu une carte ayant une structure symétrique et formée de deux coques sensiblement semblables, chacune de ces deux coques ayant une surface structurée servant à former des logements, destinés à recevoir des éléments électroniques, lorsque les deux coques sont assemblées.

Le procédé de fabrication de cette dernière carte est généralement le suivant :
- premièrement, chaque coque est fabriquée à l'aide d'une technique d'injection, par exemple par un moulage à chaud;
- deuxièmement, les éléments électroniques sont placés dans l'une des deux coques et l'autre coque est ensuite posée sur la première, le tout étant assemblé par une technique d'assemblage à chaud.

Le procédé de fabrication de la carte décrit ci-avant présente plusieurs inconvénients.

En particulier, après l'assemblage à chaud des deux coques, les éléments électroniques ne remplissent que partiellement les logements. Ceci a pour conséquence que la carte présente, dans les endroits où sont situés les logements, des zones fragiles, spécialement lorsque les éléments électroniques incorporés dans la carte ont des dimensions relativement grandes. C'est ainsi que lorsqu'il est prévu un bobinage d'un diamètre de l'ordre de grandeur de la carte, un tel procédé de fabrication engendre sur les faces extérieures de la carte des zones déformées (bombées ou creuses), ce qui est naturellement néfaste pour la planéité de la carte et pour des impressions pouvant être prévues sur les surfaces extérieures de cette carte.

On connaît encore du document EP-0 350 179 un procédé de fabrication d'une carte consistant à placer dans un moule deux couches extérieures et un ensemble électronique, puis à injecter un matériau de remplissage sous forme liquide dans ce moule. Une fois durci, ce matériau de remplissage forme une couche intermédiaire entre les deux couches extérieures.

Pour augmenter la rapidité de production, il est prévu deux chaînes comprenant chacune plusieurs demi-moules reliés les uns aux autres. Ces deux chaînes sont susceptibles d'avoir un mouvement vertical et de former avec deux demi-moules correspondants, appartenant respectivement aux deux chaînes, un moule présentant une ouverture au moins sur la partie supérieure du moule pour permettre son remplissage. Au-dessus de l'endroit où les deux demi-moules correspondants sont assemblés pour former un moule est prévue une buse permettant d'injecter le matériau de remplissage sous forme liquide dans le moule nouvellement formé.

Le procédé de fabrication d'une carte décrit ci-avant est complexe. De plus, pour de grands débits de production, ce procédé de fabrication nécessite un matériel important, ce qui le rend onéreux.

On notera encore que l'apport de l'ensemble électronique et son positionnement lors de l'injection ne sont nullement décrits dans le document considéré ici et ne sont pas évidents. Il en est de même pour l'apport des couches extérieures dans les demi-moules.

La carte obtenue par le procédé de fabrication décrit ci-avant et telle que décrite dans le document EP-0 350 179 est formée essentiellement de trois couches, à savoir d'une couche intermédiaire et deux couches extérieures. A l'intérieur de la couche intermédiaire est prévu un ensemble électronique formé d'éléments électroniques, d'une bobine disposée sur un propre support et d'un support d'interconnexion, ce support d'interconnexion servant à relier électriquement et rigidement les éléments électroniques et la bobine.

Un inconvénient majeur de cette carte provient du fait que le support d'interconnexion et le support propre à la bobine augmentent l'épaisseur de la carte. Ainsi, il est difficile d'obtenir une carte mince ayant une épaisseur de 0.76 mm prescrite par la norme ISO couramment utilisée pour les cartes bancaires.

On remarquera en outre que le procédé de fabrication proposé pour cette carte n'assure pas que le support d'interconnexion et la couche extérieure voisine soient séparés par une couche du matériau de remplissage, ce qui est néfaste pour la bonne adhérence de cette couche extérieure à la couche intermédiaire. De plus, ce procédé de fabrication ne garantit pas un bon positionnement de l'ensemble électronique au sein de la couche intermédiaire.

On connaît également du document FR 2 520 541 un procédé d'insertion d'un circuit électronique dans une carte.

Selon un premier mode de mise en oeuvre du procédé décrit, il est prévu les étapes suivantes :
- apport d'une plaque comportant un évidement préformé,
- apport dans ledit évidement d'un circuit électronique assemblé à un film-support,
- apport d'une résine polymérisable dans ledit évidement de manière à remplir ce dernier,
- apport d'une feuille de revêtement pour fermer l'évidement,
- polymérisation de ladite résine jusqu'à solidification de cette dernière,
- pressage de la feuille de revêtement contre ladite plaque et apport de chaleur pour souder à chaud cette feuille et cette plaque formées l'une et l'autre de PVC.

On connaît encore du document EP 0 481 776 une carte formée d'un substrat TAB sur lequel sont montés des éléments électroniques. Ce substrat TAB et les éléments qu'il supporte sont mis dans un enrobage pour former un module qui peut être placé dans un corps de carte comprenant un évidement à cet effet, cet évidement étant ensuite fermé par une couche supérieure.

La présente invention a pour but de pallier les inconvénients décrits ci-avant en proposant un procédé de fabrication de cartes, comportant chacune au moins un élément électronique comprise à l'intérieur d'un liant, pour un coût de fabrication bon marché, tout en garantissant des cartes de très bonne qualité.

La présente invention a comme objet un procédé de fabrication d'une carte comprenant au moins un élément électronique, caractérisé en ce qu'il comporte les étapes suivantes :
IA) apport, sur une surface de travail, d'une première couche extérieure formée d'un matériau solide;
IB) placement dudit élément électronique et de ladite bobine reliée électriquement à cet élément électronique sur ladite première couche extérieure;
IC) apport d'un liant sur ladite première couche extérieure;
ID) apport, en regard de ladite première couche extérieure et sur ledit liant, d'une deuxième couche extérieure formée d'un matériau solide;
   ces étapes étant suivies par les étapes successives suivantes :
IE) application d'une pression sur lesdites première et deuxième couches extérieures et sur ledit liant, se trouvant alors au moins partiellement dans un état non solide, jusqu'à ce que ces première et deuxième couches extérieures soient situées l'une par rapport à l'autre à une distance prédéterminée, ledit liant remplissant alors la région intermédiaire située entre ces première et deuxième couches extérieures pour former une couche intermédiaire dans laquelle sont compris ledit élément électronique et ladite bobine, au moins la majeure partie de la surface interne de chacune desdites première et deuxième couches extérieures étant recouverte par ledit liant;
IX) durcissement dudit liant de manière à solidifier ladite couche intermédiaire, cette demière ayant alors une épaisseur prédéterminée, ce liant formant alors une même masse homogène enrobant l'ensemble formé par ledit élément électronique et ladite bobine et reliant cet ensemble et les première et deuxième couches extérieures, ledit liant assurant la cohésion de ces première et deuxième couches extérieures avec ladite couche intermédiaire;
IF) découpage du contour de ladite carte de manière à former les parois latérales de cette carte.

Un autre objet selon la présente invention est défini dans la revendication 2.

Il résulte des caractéristiques décrites ci-avant un procédé de fabrication d'une carte selon l'invention nécessitant ni usinage des couches extérieures, ni de coques préformées par une technique d'injection. Les diverses étapes du procédé de fabrication- d'une carte selon l'invention sont simples et il est possible de produire des cartes selon l'invention en grande quantité pour un faible coût. De plus, il est possible de fabriquer les cartes selon l'invention sans apport de chaleur, ce qui évite les problèmes de retrait de matière pouvant survenir dans les techniques d'assemblage à chaud.

Le procédé selon l'invention permet de fabriquer des cartes compactes et pleines, c'est-à-dire présentant un volume d'air résiduel interne très petit.

Selon une autre caractéristique du procédé de fabrication d'une carte selon l'invention, il est prévu de placer, en regard de la première couche extérieure, une structure de positionnement présentant une zone interne à l'intérieur de laquelle l'élément électronique est positionné.

Cette caractéristique supplémentaire permet de positionner l'élément électronique dans une zone interne prédéfinie de la couche formée par le liant, cette structure de positionnement empêchant ledit élément électronique de sortir hors de la région intermédiaire, définie entre les surfaces internes des première et deuxième couches extérieures, spéciatement lors de l'étape IE.

Dans un mode de mise en oeuvre particulier de l'invention, il est prévu une structure de positionnement mince dont la face supérieure et la face inférieure présentent chacune un relief, les points de cette structure situés le plus à l'extérieur de son plan médian définissant une épaisseur sensiblement égale à l'épaisseur finale prévue pour la couche formée par le liant. Cette structure de positionnement permet ainsi de définir l'épaisseur de la couche de liant lors de l'étape IE durant laquelle les première et deuxième couches extérieures sont pressées l'une en direction de l'autre. Dans ce cas-ci, la structure de positionnement a donc une fonction de positionnement et une fonction de définition de l'épaisseur de la couche formée par le liant et, par conséquent, de l'épaisseur de la carte.

Selon une autre caractéristique du procédé de fabrication d'une carte selon l'invention, ledit liant apporté est formé par un liquide visqueux, ce liquide durcissant de préférence à température ambiante après ladite étape IE.

Il résulte de cette caractéristique que le liant peut se répandre de manière à remplir uniformément la région intermédiaire en enveloppant les éléments qu'elle contient pour former la couche de liant.

Dans le cas où la structure de positionnement est formée soit par un matériau alvéolé comme une mousse, soit par une structure mince présentant un relief sur sa face supérieure et sur sa face inférieure, la diffusion du liant est facilitée et un surplus du liant apporté peut être aisément évacué, ce qui empêche toute surpression néfaste lors du pressage des deux couches extérieures.

En particulier dans le cas où la structure de positionnement est formée par un cadre plein ou dans le cas où l'élément électronique est disposé avec d'autres éléments électroniques sur un substrat, il est prévu, selon un mode de mise en oeuvre particulier du procédé selon l'invention, que rapport du liant est effectué en deux phases. La première phase consiste en une application d'une première partie du liant sur ladite première couche extérieure avant le placement de l'élément électronique et de la structure de positionnement dans le cas où cette dernière est prévue. La seconde phase consiste en un apport de la seconde partie du liant une fois que l'élément électronique et, le cas échéant, la structure de positionnement sont apportés et disposés sur la première partie du liant.

Cet apport du liant en deux phases permet de garantir que les divers éléments contenus dans la couche de liant sont entièrement enveloppés par le liant, les surfaces internes des deux couches extérieures étant entièrement recouvertes par le liant, ce qui assure une très bonne cohésion entre la couche de liant et les deux couches extérieures et donc une très bonne cohésion de la carte dans son ensemble.

Dans un autre mode de mise en oeuvre du procédé de fabrication d'une carte selon l'invention, il est prévu d'utiliser une technique nécessitant un apport d'énergie. Dans ce cas-ci, le liant apporté est formé au moins par une feuille solide, cette feuille étant ensuite fondue au moins partiellement par un apport d'énergie avant l'étape IE de manière à former la couche intermédiaire après refroidissement du liant.

L'apport d'énergie servant à fondre la feuille peut être partiellement simultané à l'étape IE durant laquelle les deux couches extérieures sont pressées l'une en direction de l'autre.

Finalement, selon un autre mode de mise en oeuvre du procédé de fabrication d'une carte n'ayant pas de couches extérieures, il est prévu d'apporter l'élément électronique, la structure de positionnement et le liant directement sur une surface de travail non-adhérente à ce liant. Ensuite, le liant est pressé à l'aide d'une presse présentant une surface de contact avec le liant également non-adhérente à ce dernier.

La carte résultante de ce dernier mode de mise en oeuvre possède une unique couche formée par le liant. Cette carte peut être utilisée comme un élément constitutif dans la fabrication d'une autre carte possédant deux couches extérieures ou une coque avec un logement préformé pour recevoir cette carte.

Un autre objet de la présente invention concerne une carte, obtenue par le procédé selon la présente invention, comprenant au moins un élément électronique et une couche de liant dans laquelle est noyé l'élément électronique, cette carte étant caractérisée en ce qu'elle comprend une structure de positionnement située à l'intérieur de ladite couche de liant, cette structure depositionnement ayant au moins une ouverture principale définissant une zone interne à l'intérieur de laquelle est situé ledit élément électronique.

A titre d'exemples, le liant est une résine, en particulier un alliage de copolyamides ou une colle à deux composants, du polyuréthane ou du chlorure de polyvinyl.

Il résulte des caractéristiques mentionnées ci-avant que la structure de positionnement définit, dans la couche formée par le liant, une zone interne à l'intérieur de laquelle rélément électronique est situé. De plus, cette structure de positionnement permet de diminuer le volume de liant nécessaire et elle est avantageuse pour la fabrication de cette carte, comme cela est décrit ci-après dans le procédé de fabrication selon l'invention.

A titre d'exemples, la structure de positionnement est formée soit par un cadre plein ou perforé, soit par une feuille ondulée ou encore par une structure mince dont la face supérieure et la face inférieure sont moletées ou gauffrées, ces deux faces présentant par exemple un relief composé de plusieurs pyramides.

Selon des caractéristiques particulières de l'invention, la carte comprend des première et deuxième couches extérieures adhérant solidement audit liant, ladite couche formée par ledit liant constituant une couche intermédiaire entre lesdites première et deuxième couches extérieures, au moins la majeure partie de la surface interne de chacune de ces première et deuxième couches extérieures étant recouverte par ledit liant, ce dernier assurant la cohésion de ces première et deuxième couches extérieures avec ladite couche intermédiaire.

Dans un autre mode de réalisation, la carte selon l'invention comprend au moins un élément électronique noyé dans un liant formant partiellement cette carte, cette dernière étant caractérisée en ce qu'elle comprend en outre un support formé par une base définissant une première couche extérieure et par une structure de positionnement s'étendant depuis cette base, ledit liant recouvrant en superposition au moins la majeure partie de ladite base, ladite structure de positionnement définissant une zone interne à l'intérieur de laquelle est située ledit élément électronique.

Dans une variante de ce dernier mode de réalisation, la carte comprend en outre une deuxième couche extérieure disposée en regard de ladite base et ayant une surface interne dont au moins la majeure partie est recouverte par ledit liant, cette couche extérieure et ladite base définissant une région intermédiaire dans laquelle sont situées ladite structure de positionnement et ledit élément électronique.

On notera que le contour de la carte selon l'invention vu de dessus peut être quelconque et par exemple circulaire ou rectangulaire.

D'autres buts, caractéristiques et avantages de l'invention seront encore exposés à l'aide de la description qui suit, faite en référence aux dessins annexés qui sont donnés uniquement à titre d'exemples et sur lesquels :
- la figure 1 est une vue en perspective d'une carte, selon un premier mode de réalisation de l'invention;
- la figure 2 est une vue en coupe de la carte de la figure 1 faite selon la ligne II - II de cette figure 1;
- la figure 3 représente schématiquement et en perspective un ensemble formé d'un élément électronique et d'une bobine;
- la figure 4 est une vue de dessus schématique d'une structure de positionnement et d'un ensemble, formé d'un élément électronique et d'une bobine, compris dans la couche de liant de la carte représentée à la figure 5;
- la figure 5 est une vue similaire à la figure 2, mais représentant une carte, selon un deuxième mode de réalisation de l'invention, comportant la structure de positionnement et l'ensemble de la figure 4, lesquels sont représentés ici selon une vue en coupe faite selon la ligne V - V de cette figure 4;
- la figure 6 est une vue de dessus schématique d'une structure de positionnement et d'un ensemble, formé d'un élément électronique et d'une bobine, compris dans la couche de liant de la carte représentée à la figure 7;
- la figure 7 est une vue similaire à la figure 5, mais représentant une carte, selon un troisième mode de réalisation de l'invention, comportant les éléments de la figure 6 représentés ici selon une vue en coupe faite selon la ligne VII - VII de cette figure 6;
- la figure 8 est une vue similaire à la figure 7, mais représentant une carte selon un quatrième mode de réalisation de l'invention;
- la figure 9 représente en coupe une carte selon un cinquième mode de réalisation de l'invention;
- la figure 10 est une vue schématique en plan d'un sixième mode de réalisation d'une carte selon l'invention faite selon la ligne X - X de la figure 11;
- la figure 11 est une vue en coupe de la carte de la figure 10 faite selon la ligne XI - XI de cette figure 10.

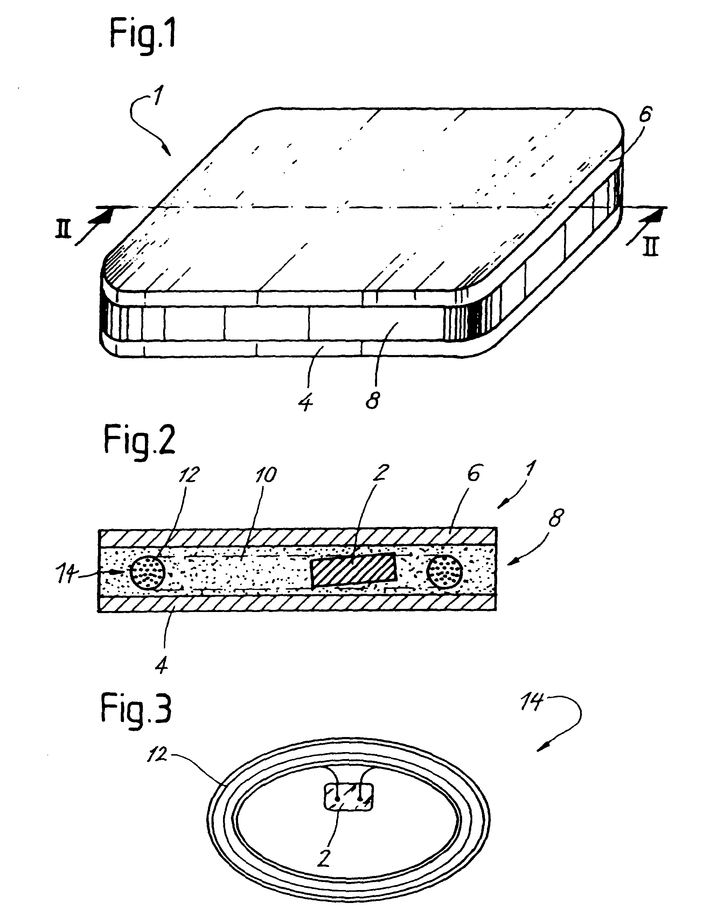

En se référant aux figures 1 à 3, on décrira ci-après un premier mode de réalisation d'une carte selon l'invention comprenant au moins un élément électronique.

La carte 1 comprend trois couches, à savoir une première couche extérieure 4, une deuxième couche extérieure 6 et une couche intermédiaire 8. La couche intermédiaire 8 est formée par un liant 10 enrobant l'élément électronique 2 et une bobine 12. On remarquera que la bobine 12 et l'élément électronique 2 sont directement reliés l'un à l'autre et forment ainsi un ensemble 14, ce dernier étant noyé dans le liant 10.

Le liant 10 est sélectionné de manière qu'il adhère correctement et solidement aux couches extérieures 4 et 6. Il assure ainsi la cohésion de l'ensemble des éléments de la carte et en particulier des deux couches extérieures 4 et 6 avec la couche intermédiaire 8.

Du fait que la bobine 12 est directement soudée sur l'élément électronique 2, sans que cet ensemble soit disposé sur un support, il est possible d'obtenir des cartes dont l'épaisseur est très faible.

Le liant 10 qui enrobe l'ensemble 14 est constitué par exemple par une résine ou un matériau plastique, ces deux exemples étant naturellement non-limitatifs. La résine peut être notamment un alliage de copolyamides, ou une colle à deux composants, ou encore une colle durcissant au contact de l'air. Les couches extérieures 4 et 6 sont constituées par exemple par une variété de chlorure de polyvinyl ou par du polyuréthane, ces exemples étant également non-limitatifs.

On remarquera que cette carte est compacte et que les couches extérieures 4 et 6 sont formées par des feuilles entièrement planes. Le liant 10 et l'ensemble 14 remplissent entièrement la région intermédiaire située entre les couches extérieures 4 et 6 pour former la couche intermédiaire 8.

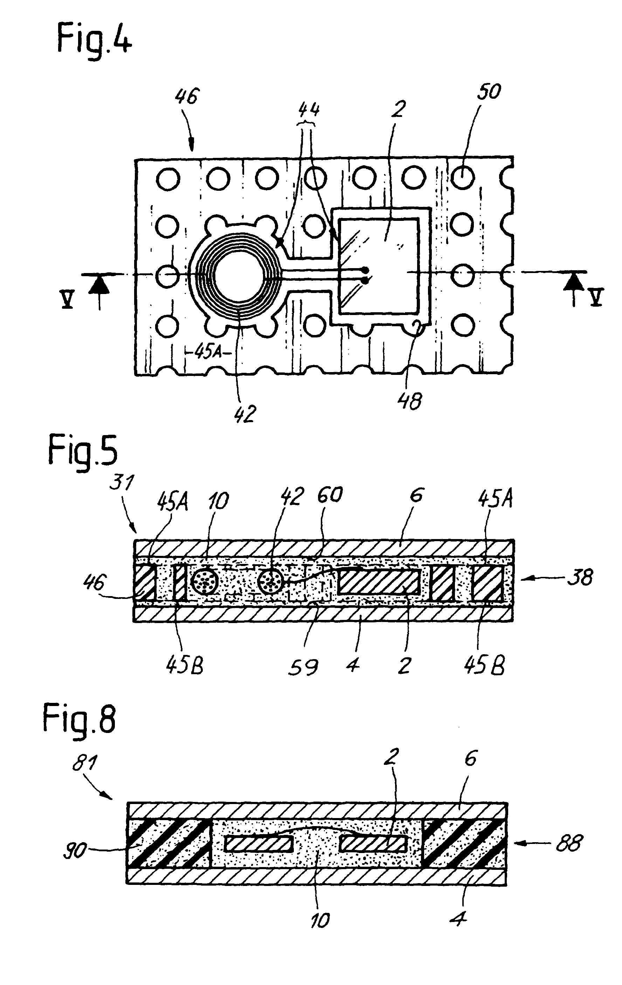

En se référant aux figures 4 et 5, on décrira ci-après un deuxième mode de réalisation d'une carte selon l'invention.

La carte 31, selon ce deuxième mode de réalisation, comprend deux couches extérieures 4 et 6, comprenant chacune une surface interne 59 et 60, et une couche intermédiaire 38 située entre les couches extérieures 4 et 6.

Un ensemble 44, formé par un élément électronique 2 relié à une bobine 42, et une structure de positionnement 46, formée par une plaque présentant une ouverture principale 48 à l'intérieur de laquelle est situé ledit ensemble 44, sont noyés dans le liant 10 et forment avec ce dernier la couche intermédiaire 38.

Cette structure 46 définit, grâce à l'ouverture principale, une zone interne pour l'ensemble 44 dans la couche intermédiaire 38.

On notera que l'élément électronique 2 est situé, sur la figure 4, à l'extérieur de la région délimitée par la bobine 42. Cette configuration est également possible pour chacun des modes de réalisation de la carte selon l'invention.

On remarquera encore que la plaque formant la structure de positionnement 46 comporte des perforations 50 remplies par le liant 10. Ces perforations permettent en particulier au liant 10 de s'écouler d'un côté à l'autre de la structure de positionnement 46 lors de la fabrication de cette carte selon un procédé faisant également l'objet de l'invention, lequel sera décrit ultérieurement.

Le liant 10 enrobe entièrement l'ensemble 44 et recouvre complètement la face supérieure 45A et la face inférieure 45B de la structure de positionnement 46. La couche intermédiaire 38 forme ainsi un amalgame compact et les surfaces internes 59 et 60 des deux couches extérieures 4 et 6 sont entièrement recouvertes par le liant 10, ce qui assure une surface d'adhérence maximale entre la couche intermédiaire 38 et les couches extérieures 4 et 6.

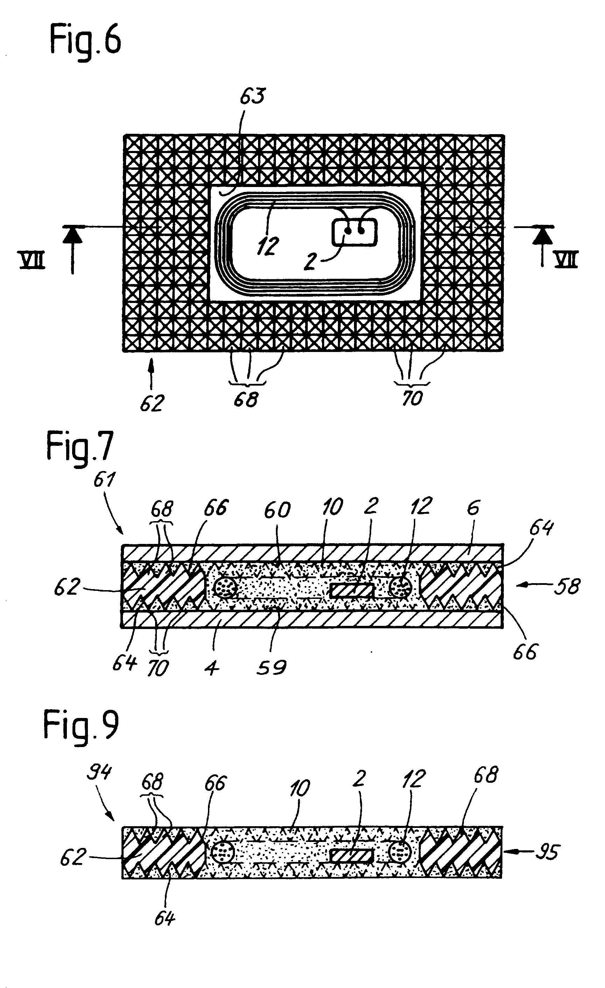

En se référant aux figures 6 et 7, on décrira ci-après un troisième mode de réalisation d'une carte selon l'invention.

La carte 61, selon ce troisième mode de réalisation, comprend une couche intermédiaire 58, située entre deux couches extérieures 4 et 6, dans laquelle est incorporée une structure de positionnement 62. Cette structure de positionnement 62 présente une ouverture principale 63 dans laquelle est situé l'ensemble 14 formé par l'élément électronique 2 et la bobine 12 tels que représentés à la figure 3.

La structure de positionnement 62 présente la forme générale d'un cadre définissant à l'intérieur de celui-ci une zone interne pour l'ensemble 14. Cette structure de positionnement 62 est formée par une structure mince présentant sur sa face supérieure 66 et sur sa face inférieure 64 un relief composé de plusieurs pyramides 68. Les pointes extérieures 70 de la structure de positionnement 62 sont légèrement écrasées et sont en contact avec les surfaces internes 59 et 60 des deux couches extérieures 4 et 6. Il est possible de prévoir une épaisseur pour la structure de positionnement 62 qui correspond exactement à l'épaisseur prévue pour la couche intermédiaire.

Ce troisième mode de réalisation présente un avantage supplémentaire étant donné que la structure de positionnement 62 sert non seulement à définir un positionnement de l'ensemble 14 dans une zone interne de la couche intermédiaire 58, mais encore à définir l'épaisseur de cette couche intermédiaire 58. Cet avantage supplémentaire est appréciable particulièrement lors de la fabrication d'une telle carte selon un procédé faisant aussi l'objet de la présente invention.

On remarquera que les pointes extérieures 70 des pyramides 68 servent de points d'appui pour les couches extérieures 4 et 6, la région avoisinant ces pointes 70 étant remplie par le liant 10. Ceci assure la bonne adhérence des couches extérieures 4 et 6 à la couche intermédiaire 58 étant donné que la majeure partie des surfaces internes 59 et 60 est recouverte par le liant 10, lequel assure la bonne cohésion de la couche intermédiaire 58 avec les couches extérieures 4 et 6.

On notera que le relief, prévu sur la face supérieure 64 et sur la face inférieure 66 de la structure de positionnement 62, peut être formé par toute une variété de motifs différents, chacun de ces motifs étant conçu de manière que la majeure partie des surfaces internes 59 et 60 des couches extérieures 4 et 6 soit recouverte par le liant 10 de la couche intermédiaire 58. La structure intermédiaire peut être fabriquée de diverses manières et en particulier par moletage ou par gaufrage.

Dans une variante de ce mode de réalisation, la structure intermédiaire est formée par une feuille ondulée. Cette feuille ondulée peut être souple ou rigide. De plus, cette feuille ondulée peut présenter des perforations ou être poreuse au liant 10.

On notera encore qu'il est possible de prévoir des perforations (non-représentées) dans la structure de positionnement 62, comme dans le cas du deuxième mode de réalisation.

En se référant ci-après à la figure 8, on décrira un quatrième mode de réalisation d'une carte selon l'invention.

La carte 81, selon ce quatrième mode de réalisation, comprend deux couches extérieures 4 et 6 et une couche intermédiaire 88 formée par un liant 10 enrobant au moins un élément électronique 2 et une structure de positionnement 90, cette structure de positionnement 90 étant formée notamment par une structure alvéolée à l'intérieur de laquelle est prévue une ouverture principale définissant une zone interne dans laquelle est disposé au moins un élément électronique 2. La structure de positionnement 90 peut aussi être formée par un matériau expansé, comme une mousse, présentant une structure rigide ou souple. Elle peut également être formée par une matière synthétique tissée.

Le liant 10 pénètre la structure de positionnement 90 de manière à former un amalgame sensiblement plein. Comme dans les modes de réalisation précédents, la couche intermédiaire 88 forme un milieu homogène et compact. De plus, le liant 10 définit une place fixe et stable pour l'élément électronique 2, ainsi que, le cas échéant, pour tous les autres éléments incorporés dans la couche intermédiaire 88. Les divers éléments prévus dans la couche intermédiaire 88 sont figés dans le liant 10 qui assure ainsi une liaison mécanique rigide entre ces divers éléments.

En se référant ci-après à la figure 9, on décrira une carte selon un cinquième mode de réalisation de l'invention.

Cette carte 94 est constituée d'une couche 95 analogue à la couche intermédiaire 58 de la carte 61 de la figure 7. Cette carte 94 est ainsi formée par un liant 10 englobant un élément électronique 2, une bobine 12, et une structure de positionnement 62 présentant un relief avec plusieurs pyramides 68 sur sa face inférieure 64 et sa face supérieure 66.

On notera que, dans d'autres variantes de ce mode de réalisation d'une carte selon l'invention, cette dernière est constituée d'une seule couche analogue à la couche intermédiaire de l'un quelconque des modes de réalisation d'une carte selon l'invention décrit ci-avant.

La carte 94 peut être utilisée comme élément constitutif d'une carte selon l'un des autres modes de réalisation décrits ci-avant. Cette carte 94 peut aussi être intégrée dans d'autres dispositifs ou objets.

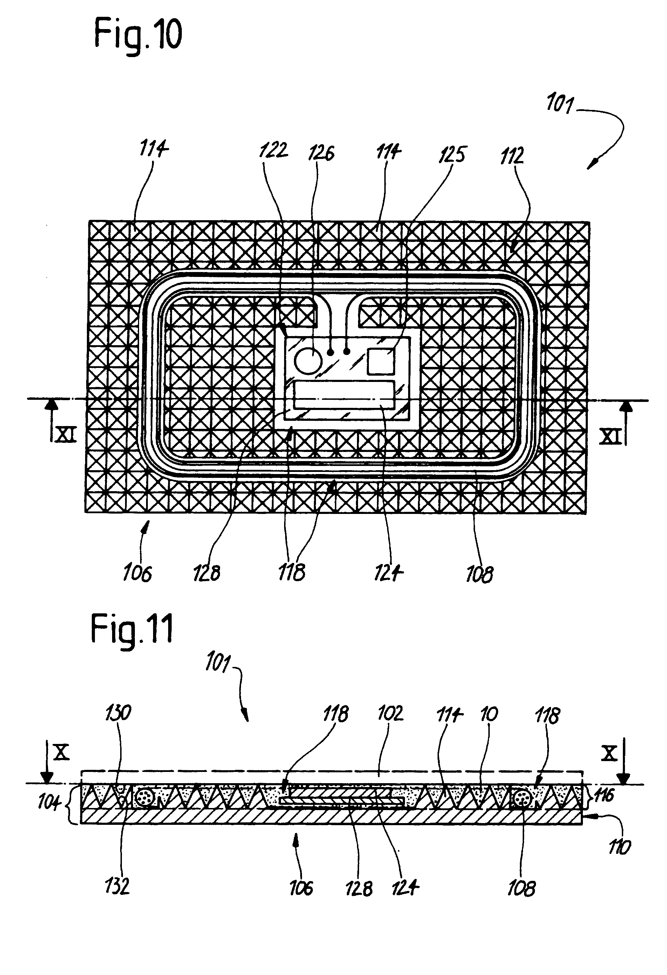

En se référant aux figures 10 et 11, on décrira ci-après un sixième mode de réalisation d'une carte selon l'invention.

Cette carte 101 comprend une couche extérieure 102 et une couche 104 formée par un support 106 et un liant 10.

Le support 106 est formé d'une base 110 et d'une structure de positionnement 112 s'étendant depuis la base 110 dans la région intermédiaire 116 de la carte 101. La base 110 définit une couche extérieure de la carte et le liant 10, remplissant l'espace laissé libre dans la région intermédiaire 116, forme une couche intermédiaire de cette carte.

La structure de positionnement 112 est quasi entièrement recouverte par le liant 10 et elle définit une zone interne 118, à l'intérieur de la région intermédiaire 116, destinée à recevoir une bobine 108 et une unité électronique 122 composée de divers éléments électroniques 124, 125 et 126. Ces éléments électroniques 124, 125 et 126 sont disposés sur un substrat 128. Le substrat 128 comporte également deux bornes de connexion avec les deux extrémités de liaison électrique de la bobine 108. On remarquera que cette dernière n'est pas disposée sur le substrat 128 de l'ensemble électronique 122, ni superposée à ce substrat 128.

La structure de positionnement 112 sert à délimiter dans la carte 101 la zone interne 118 à l'intérieur de laquelle les divers éléments électroniques sont positionnés. Cette structure de positionnement 112 est composée de plusieurs pyramides 114. Ce mode de réalisation de la structure de positionnement 112 est donnée seulement à titre d'exemple non-limitatif. En effet, le relief de la structure de positionnement 112 peut être quelconque pour autant que le volume rempli par le liant 10, comme dans les autres modes de réalisation, soit délimité par une surface dont une zone continue ou quasi continue, définissant partiellement les faces latérales de la carte selon l'invention, se développe latéralement sur tout le pourtour de la carte. En d'autres termes, le liant 10, formant partiellement la région intermédiaire 116, doit recouvrir la quasi totalité ou la totalité de la surface interne 130 de la couche extérieure 102 et de la surface interne 132 de la base 106 au moins sur l'ensemble de la région périphérique de la carte 101.

On notera que dans une variante de ce mode de réalisation, la première couche extérieure 102 est omise, la carte étant alors formée uniquement par la couche 104 englobant entièrement la structure de positionnement 112.

On remarquera encore que dans d'autres variantes de ce mode de réalisation, l'unité électronique 122 est située à l'extérieur de la région définie par la bobine 108. Ensuite, la structure de positionnement 112 peut être située seulement à l'intérieur de cette région définie par la bobine 108 ou seulement à l'extérieur de cette région.

Le sixième mode de réalisation d'une carte selon l'invention se distingue essentiellement des autres modes de réalisation décrit ci-avant par le fait que la structure de positionnement 112 forme avec la base 110 une seule et même pièce. Cette pièce peut être obtenue de plusieurs manière et en particulier par moletage, par gaufrage ou par injection.

On décrira ci-après un procédé de fabrication d'une carte selon l'invention en faisant référence aux figures 1 à 11.

Selon un premier mode de mise en oeuvre du procédé selon l'invention, une première couche extérieure 4 est apportée sur une surface de travail et au moins un élément électronique 2 est placé dessus. Un liant 10, servant à former une couche intermédiaire 8, 38, 58, 88 est apporté sur la première couche extérieure 4 dans un état liquide. Une deuxième couche extérieure 6 est apportée de manière à couvrir le liant et les divers éléments prévus dans la couche intermédiaire. Le liant 10 est apporté de préférence avec une température inférieure à la température de fusion des couches extérieures 4 et 6 et en particulier à la température ambiante.

Ensuite, les couches extérieures 4 et 6 sont pressées l'une en direction de l'autre à l'aide d'une presse. Lors de cette étape d'application d'une pression, le liant 10 se répand dans toute la région intermédiaire située entre les couches extérieures 4 et 6 de manière à le remplir sans laisser de poches d'air importantes et à enrober tous les éléments placés sur la première couche extérieure 4.

De manière avantageuse, le liant présente une viscosité suffisamment élevée pour ne s'étaler de manière importante que lors de l'application d'une pression. La consistance du liant est choisie de manière qu'il ne détériore pas l'élément électronique 2 placé sur la première couche extérieure 4, ni la bobine 12 dans le cas où celle-ci est prévue. A titre d'exemple non-limitatifs, le liant 10 est formé par une résine ou une variété de chlorure de polyvinyl pouvant être apportée sous forme liquide à une température inférieure à la température de fusion des deux couches extérieures 4 et 6.

Dans une variante de ce premier mode de mise en oeuvre, il est prévu qu'une structure de positionnement 46, 62, 90 est tout d'abord apportée sur la première couche extérieure 4. Les divers éléments, autre que cette structure de positionnement, prévus dans la couche intermédiaire sont placés ensuite à l'intérieur d'au moins une ouverture principale 48, 63 prévue dans cette structure de positionnement. Ainsi, lors de l'étape de pressage pendant laquelle le liant 10 se répand dans l'ensemble de la région intermédiaire, chaque élément est maintenu dans une zone interne prédéfinie de cette région intermédiaire à l'aide de la structure de positionnement, de sorte que les divers éléments ne sont pas emportés par l'étalement du liant dans le plan général de la carte.

On remarquera que la structure de positionnement 46, 62, 90 permet un écoulement latéral du liant 10, c'est-à-dire un écoulement dans le plan général de la carte selon l'invention. Ainsi, chacune des structures intermédiaires proposées permet d'une part de maintenir les éléments électroniques dans une zone interne prédéfinie de la région intermédiaire lors de la fabrication de la carte selon l'invention et d'autre part un écoulement du liant 10 dans toute cette région intermédiaire pour former la couche intermédiaire. De plus, elle permet qu'un surplus de liant apporté puisse s'échapper hors de la région intermédiaire définie entre les couches extérieures 4 et 6.

On notera que les perforations 50 prévues dans la structure de positionnement 46 permettent au liant 10 de s'écouler d'un côté à l'autre de cette structure de positionnement. De telles perforations évitent que le liant ne se répande que d'un seul côté de la structure de positionnement 46. On assure ainsi que le liant 10 remplit entièrement l'espace restant de la région intermédiaire.

On notera aussi que l'apport du liant peut précéder l'apport des divers éléments et structures incorporés dans la couche intermédiaire.

Dans une autre variante de ce premier mode de mise en oeuvre du procédé selon l'invention, il est prévu d'apporter une première partie du liant 10 avant les étapes de placement des divers éléments et de la structure de positionnement sur la première couche extérieure 4, une seconde partie du liant étant alors apportée après ces étapes de placement. Ainsi, on assure que les divers éléments et la structure de positionnement compris dans la couche intermédiaire sont correctement enrobés par le liant 10 de manière à ce que les surfaces internes 59 et 60 des couches extérieures 4 et 6 sont quasi-entièrement recouvertes par le liant 10, ce qui assure la bonne cohésion de la couche intermédiaire avec les couches extérieures.

Dans le cas où l'on dispose d'une structure de positionnement 62 comme représentée aux figures 6 et 7, les couches extérieures 4 et 6 sont pressées l'une en direction de l'autre jusqu'à ce qu'elles touchent les pointes 70 des pyramides 68 qui sont situées de part et d'autre de cette structure de positionnement 62. La structure de positionnement peut dans ce cas-ci présenter initialement une épaisseur légèrement supérieure à l'épaisseur désirée pour la couche intermédiaire 58, les pointes 70 des pyramides 68 de la structure de positionnement 62 étant alors légèrement écrasées lors de l'étape de pressage.

On notera ici qu'il est aussi possible d'obtenir une carte sans structure de positionnement incorporée dans la couche intermédiaire, comme cela est représenté à la figure 2, en prévoyant, lors de la fabrication d'une telle carte, un cadre de travail présentant une ouverture ayant les mêmes dimensions que celles de la carte elle-même. Le cadre de travail peut par exemple présenter une structure semblable à la structure de positionnement 62 représentée à la figure 6.

On décrira ci-après un deuxième mode de mise en oeuvre du procédé de fabrication d'une carte selon l'invention.

Dans ce deuxième mode de mise en oeuvre, on apporte une première couche extérieure 4 et on dispose dessus au moins un élément électronique 2 et une structure de positionnement comprenant une ouverture principale à l'intérieur de laquelle l'élément électronique 2 est placé. Le liant 10 est apporté dans un état solide, par exemple sous forme de feuille, et est disposé soit sur la structure de positionnement et sur les divers éléments placés sur la première couche extérieure 4, soit directement sur cette première couche extérieure. Ensuite, une deuxième couche extérieure 6 est apportée.

Dans une variante de ce deuxième mode de mise en oeuvre, il est prévu d'apporter le liant sous forme de deux feuilles minces disposées de part et d'autre de la structure de positionnement et des divers éléments incorporés dans la couche intermédiaire. Ainsi, lorsque le liant est fondu et que les couches extérieures sont pressées l'une en direction de l'autre, on assure que le liant remplit entièrement la région intermédiaire en recouvrant quasi-entièrement la structure de positionnement et les divers éléments incorporés.

A nouveau, la structure intermédiaire 46,62 ou 90 permet au liant d'avoir un écoulement latéral, un surplus de liant pouvant ainsi s'échapper hors de la région intermédiaire. De plus, la structure intermédiaire assure, le cas échéant, le maintien de la feuille de liant disposée sur celle-ci. Ainsi, lors de l'apport de chaleur, le liant pénètre de manière uniforme la structure de positionnement.

On remarquera aussi que, dans le cas où deux feuilles de liant solide sont apportées de part et d'autre de la structure de positionnement, il n'est pas forcément nécessaire de fondre ce liant jusqu'à ce qu'il soit liquide. Il suffit de le rendre suffisamment mou pour qu'il remplisse entièrement la région intermédiaire de manière à former, avec les divers éléments et la structure de positionnement, la couche intermédiaire.

Il est aussi possible, selon une autre variante de ce deuxième mode de mise en oeuvre du procédé selon l'invention, de disposer préalablement sur chacune des surfaces internes 59 et 60 des deux couches extérieures 4 et 6 un film de liant solidifié, par exemple un alliage de copolyamides ou une variété de chlorure de polyvinyl présentant un point de fusion inférieure au point de fusion des couches extérieures 4 et 6. Dans ce cas-ci, la structure de positionnement et les divers éléments sont disposés sur la première couche extérieure 4 comprenant à sa surface un film de liant solidifié, puis d'apporter la deuxième couche extérieure 6 comprenant aussi sur sa surface interne un film de liant solidifié. Comme dans les autres variantes, une presse chauffante est prévue et permet de fondre les films de liant et de presser les deux couches extérieures l'une en direction de l'autre pour former ainsi une carte selon l'invention. On notera qu'il est aussi possible dans cette variante de prévoir un seul film solide à la surface interne de l'une des deux couches extérieures 4 ou 6.

Dans le cas de la carte représentée aux figures 10 et 11, on remarquera que le procédé de fabrication de cette carte est équivalent au procédé décrit ci-avant. Dans ce cas-ci, il est bien entendu que l'apport de la première couche extérieure est simultané à l'apport de la structure de positionnement 112, cette première couche extérieure étant formée par la base 110 du support 106.

Dans le dernier cas décrit ci-avant, le liant est apporté après apport du support 106. Lorsque le liant est apporté sous forme de feuille solide, cette feuille est apportée sur la structure de positionnement 112. De la même manière que précédemment, le liant solide peut être préalablement assemblé avec la couche extérieure 102. A titre d'exemple, le liant solide est formé par une couche de chlorure de polyvinyl assemblée avec la couche extérieure 102 et présentant un point de fusion inférieur au point de fusion de cette couche extérieure 102.

On notera que dans le cas de la carte représentée à la figure 8, il est possible d'apporter simultanémenet la structure de positionnement 90 et le liant 10, ce dernier pouvant être imprégné dans la structure de positionnement 90 avant que celle-ci soit apportée.

Selon un troisième mode de mise en oeuvre du procédé de fabrication d'une carte 94 selon l'invention, il est prévu de placer au moins un élément électronique 2 sur une surface de travail et d'apporter directement sur cette surface de travail un liant 10. Ensuite, une pression est appliquée sur le liant 10 en direction de la surface de travail à l'aide d'une presse, présentant une surface de contact avec le liant 10, jusqu'à ce que le liant forme une couche 95 d'une épaisseur prédéterminée.

La surface de travail et la surface de contact de la presse sont non-adhérentes au liant. Par exemple, elles sont recouvertes de teflon. On notera que la bobine et, le cas échéant, la structure de positionnement sont apportées avant l'étape d'application d'une pression et sont intégrées dans la couche 95 formant la carte 94.

A nouveau, la structure de positionnement permet de positionner l'élément électronique 2 et la bobine 12 dans une zone interne prédéterminée de la couche 95. En particulier, cette structure permet de maintenir dans cette zone interne l'élément électronique et la bobine lors de l'étape d'application d'une pression.

Le liant 10 est apporté sous une forme liquide présentant de préférence une viscosité suffisamment élevée pour ne s'étaler de manière importante que lorsqu'une pression est appliquée sur le liant.

On remarquera qu'au moins une partie du liant 10 peut être apportée, dans une variante de ce troisième mode de mise en oeuvre, sous forme d'au moins une feuille solide, cette feuille étant ensuite fondue au moins partiellement pour former la couche 95 contenant l'élément électronique 2, la bobine 12 et la structure de positionnement 62.

Dans cette variante, il est possible de placer la feuille de liant directement sur la surface de travail et les divers éléments prévus sur cette feuille de liant. L'apport d'énergie est alors fourni de préférence par la surface de travail de manière à fondre la feuille de liant sans élever trop la température des divers éléments.

La variante décrite ci-avant est particulièrement avantageuse lorsqu'aucune structure de positionnement n'est prévue. En effet, si on fait fondre la feuille de liant de manière judicieuse pour qu'elle présente une consistance molle et déformable, mais non-liquide, il est alors possible d'enfoncer l'élément électronique et la bobine à l'aide de la presse sans qu'ils ne subissent un déplacement latéral significatif. Ainsi, l'élément électronique et la bobine gardent approximativement la position dans laquelle ils ont été disposés sur la feuille de liant.

On notera que ce qui vient d'être mentionné est aussi valable dans le cas du deuxième mode de mise en oeuvre du procédé selon l'invention, la feuille de liant étant alors disposée directement sur la couche extérieure 4 et l'apport de chaleur à la feuille de liant étant effectué par la surface de travail au travers de cette couche extérieure 4. Dans ce dernier cas, il est prévu que le point de fusion du liant soit inférieur au point de fusion des couches extérieures.

Selon un quatrième mode de mise en oeuvre du procédé de fabrication d'une carte 1, 31, 61, 81 selon l'invention, il est prévu de fabriquer dans une première phase une carte 95 selon le troisième mode de mise en oeuvre du procédé décrit ci-avant. Ensuite, dans une deuxième phase, deux couches extérieures 4 et 6 sont disposées de part et d'autre de la carte 95 pour former une carte 1, 31, 61, 81 selon l'invention.

Dans une première variante, il est prévu un apport d'énergie servant à fondre au moins superficiellement la carte 95 de telle manière que le liant 10, formant cette carte 95, adhère solidement aux deux couches extérieures après une étape de refroidissement.

Ainsi, la carte 94 initialement fabriquée est un élément constitutif d'une nouvelle carte 1, 31, 61, 81 dont elle forme la couche intermédiaire 8, 38, 58, 88.

Dans une seconde variante de ce quatrième mode de mise en oeuvre du procédé selon l'invention, il est prévu d'appliquer un film de colle sur les surfaces internes 59 et 60 des deux couches extérieures 4 et 6 et/ou sur les deux faces correspondantes de la carte 95 formant la couche intermédiaire 1, 31, 61, 81 de la carte fabriquée selon ce quatrième mode de mise en oeuvre, le tout étant assemblé à température ambiante.

On notera ici que dans tout le présent texte, le liant 10 peut être formé de plusieurs matériaux. De même, la couche 8, 38, 58, 88, 95 de liant 10 peut être formée de plusieurs sous-couches ou films de matériaux différentes. Ainsi, dans la seconde variante décrite ci-avant, la carte 95 et les deux films de colle forment ensemble la couche intermédiaire 8, 38, 58, 88.

Dans une troisième variante du quatrième mode de mise en oeuvre du procédé selon l'invention, il est prévu de placer la carte 95 initialement fabriquée dans un cadre présentant une ouverture dont le profil correspond sensiblement à celui de la carte 95. Ensuite, l'assemblage de la carte 1, 31, 61, 81 selon cette troisième variante est effectué à l'aide de deux films de colle de manière semblable à la deuxième variante décrite précédemment. Lors de l'application des films de colle, les deux faces du cadre situées respectivement en regard des couches extérieures 4 et 6 sont aussi recouvertes par la colle.

On remarquera que le procédé de fabrication selon l'invention permet, dans chacun de ses modes de mise en oeuvre, de fabriquer plusieurs cartes en même temps. Pour ce faire, on fabrique une plaque correspondant à plusieurs cartes. Cette plaque est fabriquée selon le procédé de l'invention décrit ci-avant, une étape finale de découpe de chaque carte étant prévue après fabrication de la plaque.

Dans ce cas-ci, il est particulièrement avantageux de prévoir une structure de positionnement ayant les dimensions de la plaque et présentant plusieurs ouvertures principales distribuées avec une certaine période de répétition. Chaque période est prévue pour une carte. Dans chaque ouverture principale est disposé au moins un élément électronique.

Etant donné que la structure de positionnement présente des ouvertures principales bien définies servant à positionner les divers éléments prévus, il est possible, lors de la découpe des cartes dans la plaque, de garantir qu'aucun des divers éléments disposés dans les ouvertures principales de la structure de positionnement ne soit sectionné ou endommagé. Pour ce faire, le tracé de découpe des cartes est choisi de telle manière que ce tracé n'intercepte jamais une desdites ouvertures principales de la structure de positionnement.

On remarquera encore que ce qui vient d'être décrit reste aussi vrai pour la fabrication d'une seule carte à partir d'une plaque ayant des dimensions supérieures à cette carte.

On notera que, lors du procédé de fabrication d'une carte selon l'invention décrit ci-avant, un cadre de travail peut être disposé sur la surface de travail, les divers éléments prévus dans la couche de liant et le liant lui-même étant apportés à l'intérieur de ce cadre de travail. Afin de permettre l'évacuation d'un surplus de liant lors de l'étape d'application d'une pression, il est prévu que ce cadre soit perméable audit liant au moins lorsque ce dernier est soumis à une surpression.

On notera encore que tout moyen connu d'apport de chaleur, dans les modes de mise en oeuvre du procédé nécessitant un tel apport, est envisageable, par exemple un apport de chaleur par micro-ondes. De même, tout moyen connu de solidification du liant choisi est envisageable, par exemple une polymérisation par ultraviolet.

Finalement, il est sans autre possible de combiner le premier ou le deuxième mode de mise en oeuvre du procédé selon l'invention avec le troisième mode de mise en oeuvre de ce procédé pour fabriquer une carte selon l'invention possédant une seule couche extérieure et une couche formée par le liant. Dans le cas des figures 10 et 11, cette seule couche extérieure correspond à la base du support.

## Revendications

1. Procédé de fabrication d'une carte (1;31;61;81;101) comprenant au moins un élément électronique (2;125) et une bobine (12; 42; 108), **caractérisé en ce qu'**il comporte les étapes suivantes :
IA) apport, sur une surface de travail, d'une première couche extérieure (4;110) formée d'un matériau solide;
IB) placement dudit élément électronique et de ladite bobine reliée électriquement à cet élément électronique sur ladite première couche extérieure (4;110);
IC) apport d'un liant (10) sur ladite première couche extérieure;
ID) apport, en regard de ladite première couche extérieure et sur ledit liant, d'une deuxième couche extérieure (6;102) formée d'un matériau solide;
ces étapes étant suivies par les étapes successives suivantes :
IE) application d'une pression sur lesdites première et deuxième couches extérieures (4;110 et 6;102) et sur ledit liant, se trouvant alors au moins partiellement dans un état non solide, jusqu'à ce que ces première et deuxième couches extérieures soient situées l'une par rapport à l'autre à une distance prédéterminée, ledit liant remplissant alors la région intermédiaire située entre ces première et deuxième couches extérieures pour former une couche intermédiaire (8;38;58;88) dans laquelle sont compris ledit élément électronique et ladite bobine, au moins la majeure partie de la surface interne de chacune desdites première et deuxième couches extérieures étant recouverte par ledit liant;
IX) durcissement dudit liant (10) de manière à solidifier ladite couche intermédiaire, cette dernière ayant alors une épaisseur prédéterminée, ce liant formant alors une même masse homogène enrobant l'ensemble formé par ledit élément électronique et ladite bobine et reliant cet ensemble et les première et deuxième couches extérieures, ledit liant assurant la cohésion de ces première et deuxième couches extérieures avec ladite couche intermédiaire;
IF) découpage du contour de ladite carte de manière à former les parois latérales de cette carte.

2. Procédé de fabrication d'une carte (94) comprenant au moins un élément électronique (2) et une bobine (12; 42), **caractérisé en ce qu'**il comporte les étapes suivantes :
IB) placement dudit élément électronique et de ladite bobine reliée électriquement à cet élément électronique sur une surface de travail;
IC) apport d'un liant (10) sur ladite surface de travail, cette surface de travail étant non-adhérente audit liant;
ces étapes étant suivies par les étapes successives suivantes :
IE) application d'une pression sur ledit liant, se trouvant alors au moins partiellement dans un état non solide, en direction de ladite surface de travail à l'aide d'une presse présentant une surface de contact avec ledit liant non-adhérente à ce dernier, jusqu'à ce que ledit liant forme une couche (95) dans laquelle est compris l'ensemble formé par ledit élément électronique et ladite bobine, cet ensemble étant enrobé par ledit liant;
IX) durcissement dudit liant (10) de manière à solidifier ladite couche, cette dernière ayant alors une épaisseur prédéterminée;
IF) découpage du contour de ladite carte de manière à former les parois latérales de cette carte.

3. Procédé selon la revendication 1 ou 2, **caractérisé en ce qu'**il comprend, avant ladite étape IE, l'étape suivante :
IG) apport d'une structure de positionnement (46;62;90;112), définissant une zone interne (48;63;118) pour positionner ledit ensemble, de manière que cet ensemble est situé à l'intérieur de ladite zone interne;
cette structure de positionnement étant située à l'intérieur de ladite couche formée par ledit liant après ladite étape IE.

4. Procédé selon la revendication 3, **caractérisé en ce que** ladite zone interne est définie par une ouverture principale (48;63) prévue dans ladite structure de positionnement (46;62;90).

5. Procédé selon la revendication 4, **caractérisé en ce que** ladite structure de positionnement (46) présente une épaisseur inférieure à ladite épaisseur prédéterminée de ladite couche (38) formée par ledit liant (10).

6. Procédé selon l'une des revendications 3 à 5, **caractérisé en ce que** ladite structure de positionnement (62;112), une fois apportée, présente, dans un plan sensiblement parallèle à ladite surface de travail, un relief sur sa face inférieure.

7. Procédé selon l'une des revendications 3 à 6, **caractérisé en ce que** ladite structure de positionnement (62;112), une fois apportée, présente dans un plan sensiblement parallèle à ladite surface de travail, un relief sur sa face supérieure.

8. Procédé selon l'une quelconque des revendications précédentes, **caractérisé en ce que** ledit liant (10) apporté est formé par une substance liquide visqueuse.

9. Procédé selon la revendication 8, **caractérisé en ce que** ledit liant (10) apporté est formé par une résine, cette résine étant apportée avec une température peu élevée et durcissant à température sensiblement ambiante entre lesdites étapes IE et IF.

10. Procédé selon l'une quelconque des revendications 3 à 7 et la revendication 8 ou 9, **caractérisé en ce que** ledit apport dudit liant (10) est effectué en deux phases, la première phase consistant en une application d'une première partie dudit liant avant lesdites étapes IB et IG et la seconde phase consistant en un apport d'une seconde partie dudit liant (10) après ladite étape IG.

11. Procédé selon l'une quelconque des revendications 3 à 7, **caractérisé en ce qu'**au moins une partie dudit liant (10) apporté est formé par une feuille solide, cette feuille étant ensuite fondue au moins partiellement par un apport d'énergie avant l'étape IE, ladite étape de durcissement comportant un refroidissement dudit liant.

12. Procédé selon l'une quelconque des revendications 3 à 7, **caractérisé en ce que** ledit liant (10) apporté est formé par deux feuilles solides disposées de part et d'autre de ladite structure de positionnement (46;62;90), ces deux feuilles étant ensuite fondues au moins partiellement par un apport d'énergie avant l'étape IE, ladite étape de durcissement comportant un refroidissement dudit liant.

13. Procédé de fabrication d'une carte selon la revendication 2, **caractérisé en ce qu'**il comprend les étapes ultérieures et successives suivantes :
II) apport de première et deuxième couches extérieures (4 et 6) formées chacune d'un matériau solide;
IJ) apport de ladite couche formée par ledit liant (10) entre lesdites première et deuxième couches extérieures;
IK) apport d'énergie servant à fondre au moins superficiellement ladite couche formée par ledit liant pour faire adhérer cette couche auxdites première et deuxième couches extérieures, cette couche formant après refroidissement une couche intermédiaire (8;38;58;88) entre ces première et deuxième couches extérieures.

14. Procédé de fabrication d'une carte selon la revendication 2, **caractérisé en ce qu'**il comprend les étapes ultérieures et successives suivantes :
III) apport de première et deuxième couches extérieures présentant chacune une surface sur laquelle est déposé un film de colle;
IIJ) apport de ladite couche formée par ledit liant (10) entre lesdites première et deuxième couches extérieures;
IIK) durcissement de chaque film de colle assurant l'adhérence desdites première et deuxième couches extérieures avec ladite couche formée par ledit liant (10).

15. Procédé de fabrication d'une carte selon l'une quelconque des revendications précédentes, **caractérisé en ce qu'**il est prévu un cadre de travail disposé sur ladite surface de travail, ledit liant (10) étant apporté à l'intérieur dudit cadre de travail, ce cadre de travail étant agencé pour laisser passer ledit liant lorsque ce dernier est soumis à une surpression et permettant qu'un surplus de liant puisse s'échapper lors de ladite étape IE.

16. Carte (31;61;81;94), obtenue par le procédé selon l'une quelconque des revendications 3 à 7, comprenant au moins un élément électronique (2) et une bobine (12; 42) reliée électriquement à cet élément électronique, une couche (38;58;88;95) formée par un liant (10) dans lequel est noyé l'ensemble formé par ledit élément électronique et ladite bobine, cette carte étant **caractérisée en ce qu'**elle comprend une structure de positionnement (46;62;90) située à l'intérieur de ladite couche (38;58;88;95) formée par ledit liant (10), cette structure de positionnement définissant une zone interne à l'intérieur de laquelle est situé ledit ensemble, ladite zone interne étant formée par une ouverture principale (48;63) traversant ladite structure de positionnement (46;62;90).

17. Carte selon la revendication 16, **caractérisée en ce que** ladite bobine (12;42) a deux extrémités de liaison électrique reliées audit élément électronique (2).

18. Carte (31;61;81) selon l'une des revendications 16 et 17, **caractérisée en ce qu'**elle comprend des première et deuxième couches extérieures (4 et 6), ladite couche (38;58;88) formée par ledit liant constituant une couche intermédiaire entre lesdites première et deuxième couches extérieures, au moins la majeure partie de la surface interne (59,60) de chacune de ces première et deuxième couches extérieures étant recouverte par ledit liant, ce dernier assurant la cohésion de ces première et deuxième couches extérieures avec ladite couche intermédiaire.

19. Carte selon l'une quelconque des revendications 16 à 18, **caractérisée en ce que** ladite structure de positionnement (62) est formée par une structure mince présentant sur sa face inférieure (64) un relief (68).

20. Carte selon l'une quelconque des revendications 16 à 19, **caractérisée en ce que** ladite structure de positionnement (62) présente sur sa face supérieure (66) un relief.

21. Carte selon l'une quelconque des revendications 16 à 18, **caractérisée en ce que** ladite structure de positionnement (90) est formée par une structure alvéolée.

22. Carte selon l'une quelconque des revendications 16 à 18, **caractérisée en ce que** ladite structure de positionnement (90) est formée par un matériau expansé.

23. Carte selon l'une quelconque des revendications 16 à 22, **caractérisée en ce que** ladite structure de positionnement (62) a la forme générale d'un cadre.

## Patentansprüche

1. Verfahren zum Herstellen einer Karte (1; 31; 61; 81; 101) mit mindestens einem elektronischen Element (2; 125) und einer Spule (12; 42; 108), **dadurch gekennzeichnet, dass** es die nachstehenden Schritte umfasst:
IA) Auflegen einer ersten äusseren Schicht (410), gebildet aus einem festen Material, auf eine Arbeitsoberfläche;
IB) Plazieren des elektronischen Elements und der mit diesem elektronischen Element elektrisch verbundenen Spule auf der ersten äusseren Schicht (4; 110);
IC) Aufbringen eines Bindemittels (10) auf die erste äussere Schicht;
ID) Aufbringen, gegenüber der ersten äusseren Schicht und auf das Bindemittel, einer zweiten äusseren Schicht (6; 102), gebildet aus einem festem Material;
welchen Schritten aufeinanderfolgend die nachstehenden Schritte folgen :
IE) Aufbringen eines Druckes auf die erste und zweite äussere Schicht (4;110 und 6;102) und auf das Bindemittel, das sich dabei zumindest teilweise in einem nichtfesten Zustand befindet, bis diese erste und zweite äussere Schicht einander gegenüber mit einem vorbestimmten Abstand befindlich sind, wobei das Bindemittel dann den Zwischenbereich füllt, der sich zwischen der ersten und der zweiten äusseren Schicht befindet, um eine Zwischenschicht (8;38;58;88) zu bilden, in der sich das elektronische Element und die Spule befinden, wobei mindestens die Hauptpartie der Innenoberfläche jeder der ersten und der zweiten äusseren Schicht von dem Bindemittel bedeckt ist;
IX) Aushärtenlassen des Bindemittels (10) derart, dass die Zwischenschicht sich verfestigt, welche letztere dabei eine vorbestimmte Dicke hat, wobei dieses Bindemittel dann eine gleiche homogene Masse bildet, welche die durch das elektronische Element und die Spule gebildete Einheit umhüllt sowie diese Einheit und die erste und die zweite äussere Schicht verbindet, welches Bindemittel die Kohäsion dieser ersten und dieser zweiten äusseren Schicht mit der Zwischenschicht garantiert.
IF) Ausschneiden der Kontur der Karte derart, dass die Seitenwandungen der Karte gebildet werden.

2. Verfahren zum Herstellen einer Karte (94) mit mindestens einem elektronischen Element (2) und einer Spule (12; 42), **dadurch gekennzeichnet, dass** es die nachstehenden Schritte umfasst :
IB) Plazieren des elektronischen Elementes und der mit diesem elektronischen Element elektrisch verbundenen Spule auf eine Arbeitsfläche;
IC) Aufbringen eines Bindemittels (10) auf die Arbeitsfläche, welche Arbeitsfläche an dem Bindemittel nichthaftend ist;
welchen Schritten in dieser Reihefolge die nachstehenden Schritte folgen :
IE) Aufbringen eines Drucks auf das Bindemittel, das sich dabei mindestens teilweise in einem nichtfesten Zustand befindet, in Richtung auf die Arbeitsfläche mit Hilfe einer Presse, die eine an dem Bindemittel nichthaftende Kontaktflache besitzt, bis das Bindemittel eine Schicht (95) bildet, in der die durch das elektronische Element und die Spule gebildete Einheit enthalten ist, wobei diese Einheit durch das Bindemittel umhüllt wird;
IX) Aufhärten des Bindemittels (10) derart, dass diese Zwischenschicht sich verfestigt, welche letztere dabei eine vorbestimmte Dicke hat;
IF) Ausschneiden der Kontur der Karte derart, dass die Seitenwandungen dieser Karte gebildet werden.

3. Verfahren nach Anspruch 1 oder 2, **dadurch gekennzeichnet, dass** es vor dem Schritt IE den folgenden Schritt umtasst :
IG) Aufbringen einer Positionierstruktur (46;62;90;112), die eine interne Zone (48,63;118) begrenzt zum Positionieren der Einheit derart, dass diese Einheit sich im Inneren der internen Zone befindet; wobei sich diese Positionierstruktur nach dem Schritt IE innerhalb der durch das Bindemittel gebildeten Schicht befindet.

4. Verfahren nach Anspruch 3, **dadurch gekennzeichnet, dass** die interne Zone von einer Hauptöffnung (48;63) definiert wird, vorgesehen in der Positionierstruktur (46;62;90).

5. Verfahren nach Anspruch 4, **dadurch gekennzeichnet, dass** die Positionierstruktur (46) eine Dicke besitzt, die kleiner ist als die vorbestimmte Dicke der Schicht (38), die von dem Bindemittel (10) gebildet wird.

6. Verfahren nach einem der Ansprüche 3 bis 5, **dadurch gekennzeichnet, dass** die Positionierstruktur (62;112) nach dem Aufbringen einer Ebene im wesentlichen parallel zu der Arbeitsoberfläche ein Relief auf seiner Unterseite aufweist.

7. Verfahren nach einem der Ansprüche 3 bis 6, **dadurch gekennzeichnet, dass** die Positionierstruktur (62;112) nach dem Aufbringen in einer Ebene im wesentlichen parallel zu der Arbeitsoberfläche ein Relief auf seiner Oberseite aufweist.

8. Verfahren nach einem der vorangehenden Ansprüche, **dadurch gekennzeichnet, dass** das aufgebrachte Bindemittel (10) von einer flüssigen viskosen Substanz gebildet wird.

9. Verfahren nach Anspruch 8, **dadurch gekennzeichnet, dass** das aufgebrachte Bindemittel (10) von einem Harz gebildet wird, welches Harz mit einer etwas erhöhten Temperatur aufgebracht wird und bei einer Temperatur im wesentlichen entsprechend der Umgebung zwischen den Schritten IE und IF aushärtet.

10. Verfahren nach einem der Ansprüche 3 bis 7 und Ansprüchen 8 oder 9, **dadurch gekennzeichnet, dass** das Aufbringen des Bindemittels (10) in zwei Phasen vorgenommen wird, wobei die erste Phase daraus besteht, da6 eine erste Partie des Bindemittels vor den Schritten IB und IG aufgebracht wird und die zweite Phase darin besteht, dass eine zweite Partie des Bindemittels (10) nach dem Schritt IG aufgebracht wird.

11. Verfahren nach einem der Ansprüche 3 bis 7, **dadurch gekennzeichnet, dass** mindestens eine Partie des aufgebrachten Bindemittels (10) von einer festen Folie gebildet wird, welche Folie danach mindestens teilweise durch Zufuhr von Energie vor dem Schritt IE aufgeschmolzen wird, welcher Schritt des Aushärtens eine Abkühlung des Bindemittels umfasst.

12. Verfahren nach einem der Ansprüche 3 bis 7, **dadurch gekennzeichnet, dass** das aufgebrachte Bindemittel (10) von zwei festen Folien gebildet wird, die beidseits der Positionierstruktur (46;62;90) angeordnet werden, welche beiden Folien danach mindestens teilweise durch Zufuhr von Energie vor dem Schritt IE aufgeschmolzen werden, wobei der Schritt des Aushärtens eine Abkühlung des Bindemittels umfasst.

13. Verfahren zum Herstellen einer Karte nach Anspruch 2, **dadurch gekennzeichnet, dass** es die abschliessenden nachgenannten Schritte in dieser Reihenfolge umfasst :
II) Aufbringen von ersten und zweiten äusseren Schichten (4 bis 6), jeweils von einem festen Material gebildet;
IJ) Aufbringen der von dem Bindemittel (10) gebildeten Schicht zwischen der ersten und zweiten Aussenschicht;
IK) Zufuhr von Energie, die dazu dient, mindestens oberflächlich die Schicht aufzuschmelzen, die von dem Bindemittel gebildet wird, um diese Schicht an der ersten und zweiten Aussenschicht zum Anhaften zu bringen, welche Schicht nach dem Abkühlen eine Zwischenschicht (8;38;58;88) zwischen der ersten und der zweiten Aussenschicht bildet.

14. Verfahren zum Herstellen einer Karte nach Anspruch 2, **dadurch gekennzeichnet, dass** es die abschliessenden Schritte in der nachstehenden Reihenfolge umfasst :
III) Aufbringen einer ersten und einer zweiten äusseren Schicht mit jeweils einer Oberfläche, auf der ein Klebstoff-Film aufgebracht ist;
IIJ) Einfügen der von dem Bindemittel (10) gebildeten Schicht zwischen der ersten und der zweiten Aussenschicht;
IIK) Aushärten jedes Klebstoff-Films zum Sicherstellen des Anhaftens der ersten und der zweiten äusseren Schicht an der von dem Bindemittel (10) gebildeten Schicht.

15. Verfahren zur Herstellung einer Karte nach einem der vorangehenden Ansprüche, **dadurch gekennzeichnet, dass** ein Arbeitsrahmen vorgesehen wird, der auf der Arbeitsfläche angeordnet ist, wobei das Bindemittel (10) in das Innere des Arbeitsrahmens eingefügt wird, welcher Arbeitsrahmen ausgebildet ist, um das Bindemittel passieren zu lassen, wenn dieses letztere einem Überdruck ausgesetzt wird und ermöglicht, dass ein Überschuss an Bindemittel wahrend des Schrittes IE entweichen kann.

16. Karte (31; 61; 81; 94), erhalten mittels des Verfahrens nach einem der Ansprüche 3 bis 7, umfassend mindestens ein elektronisches Element (2) und eine elektrisch mit diesem elektronischen Element verbundene Spule sowie eine Schicht (38; 58; 88; 95) die von einem Bindemittel (10) gebildet ist, in dem die durch das elektronische Element und die Spule gebildete Einheit eingebettet ist, welche Karte **dadurch gekennzeichnet ist, dass** sie eine Positionierstruktur (46; 62; 90) umfasst, angeordnet im Inneren der von dem Bindemittel (10) gebildeten Schicht (38; 58; 88; 95), welche Positionierstruktur eine interne Zone begrenzt, in deren Inneren sich die Einheit befindet, wobei die interne Zone von einer Hauptöffnung (48;63) gebildet wird, welche die Positionierstruktur (46,62,90) durchsetzt.

17. Karte nach Anspruch 16, **dadurch gekennzeichnet, dass** die Spule (12;42) zwei elektrische Verbindungsenden umfasst, die mit dem elektronischen Element (2) verbunden sind.

18. Karte (31;61;81) nach einem der Ansprüche 16 und 17, **dadurch gekennzeichnet, dass** sie eine erste und eine zweite Aussenschicht (4 bzw. 6) umfasst, wobei die von dem Bindemittel gebildete Schicht (38;58;88) eine Zwischenschicht zwischen der ersten und der zweiten Au8enschicht bildet, wobei mindestens der Hauptteil der Innenoberfläche (59;60) jeder der ersten und zweiten Aussenschichten mit dem Bindemittel beschichtet ist, welches letztere die Kohäsion der ersten und zweiten Aussenschicht an der Zwischenschicht sicherstellt.

19. Karte nach einem der Ansprüche 16 bis 18, **dadurch gekennzeichnet, dass** die Positionierstruktur (62) von einer dünnen Struktur gebildet ist, die auf ihrer Unterseite (64) ein Relief (68) aufweist.

20. Karte nach einem der Ansprüche 16 bis 19, **dadurch gekennzeichnet, dass** die Positionierstruktur (62) auf ihrer Oberseite (66) ein Relief aufweist.

21. Karte nach einem der Ansprüche 16 bis 18, **dadurch gekennzeichnet, dass** die Positionierstruktur (90) von einer Alveolenstruktur gebildet ist.

22. Karte nach einem der Ansprüche 16 bis 18, **dadurch gekennzeichnet, dass** die Positionierstruktur (90) von einem expandierten Material gebildet ist.

23. Karte nach einem der Ansprüche 16 bis 22, **dadurch gekennzeichnet, dass** die Positionierstruktur (62) die allgemeine Form eines Rahmens besitzt.

## Claims

1. Method of manufacture of a card (1; 31; 61; 81; 101) comprising at least one electronic element (2; 125) and a coil (12; 42; 108), **characterized in that** it includes the following steps :
IA) bringing onto a work surface a first outer layer (4; 110) formed from a solid material;
IB) placing said electronic element and said coil electrically connected to said electronic element onto said first outer layer (4; 110);
IC) bringing a binding material (10) onto said first outer layer;
ID) bringing a second outer layer (6; 102) formed from a solid material onto said binding material and facing said first outer layer;
such steps being succeeded by the following steps :
IE) applying pressure on said first and second outer layers (4; 110 and 6; 102) and on said binding material, then being at least partially in a non-solid state, until such first and second outer layers are located at a predetermined distance relative to one another, said binding material then filling the intermediate region located between such first and second outer layers in order to form an intermediate layer (8; 38; 58; 88) in which said electronic element and said coil are comprised, at least the major portion of the internal surface of each of said first and second outer layers being covered over by said binding material;
IX) hardening said binding material (10) in order to solidify said intermediate layer, the latter then having a predetermined thickness, this binding material then forming a same homogeneous mass encasing the assembly formed by said electronic element and said coil and binding this assembly and said first and second outer layers, said binding material assuring cohesion of these first and second outer layers with said intermediate layer.
IF) cutting out a contour of said card in order to form the lateral walls of such card.

2. Method of manufacture of a card (94) comprising at least one electronic element (2) and a coil (12; 42), **characterized in that** it includes the following steps :
IB) placing said electronic element and said coil electrically connected to said electronic element onto a work surface;
IC) bringing a binding material (10) onto said work surface, such work surface being non-adhesive to said binding material;
such steps being succeeded by the following steps :
IE) applying pressure on said binding material, then being at least partially in a non-solid state, in the direction of said work surface with the help of a press exhibiting a contact surface with said binding material non-adhesive thereto until said binding material forms a layer (95) in which the assembly formed by said electronic element and said coil is comprised, this assembly being encased by said binding material;
IX) hardening said binding material (10) in order to solidify said layer, the latter then having a predetermined thickness;
IF) cutting out a contour of said card in order to form the lateral walls of such card.

3. Method according to claim 1 or 2, **characterized in that** it comprises the following step prior to step IE :
IG) bringing a positioning structure (46; 62; 90; 112) defining an internal zone (48; 63; 118) in order to position said assembly in a manner such that said assembly is located within said internal zone, this positioning structure being situated at the interior of said layer formed by said binding material after said step IE.

4. Method according to claim 3, **characterized in that** said internal zone is defined by a principal opening (48; 63) provided in said positioning structure (46; 62; 90)

5. Method according to claim 4, **characterized in that** said positioning structure (46) is planar and exhibits a thickness less that said predetermined thickness of said layer (38) formed by said binding material (10).

6. Method according to one of claims 3 to 5, **characterized in that** said positioning structure (62; 112), once brought, exhibits a relief on its lower face in a plane substantially parallel to said work surface.

7. Method according to one of claims 3 to 6, **characterized in that** said positioning structure (62; 112), once brought, exhibits a relief on its upper face in a plane substantially parallel to said work surface.

8. Method according to any one of the preceding claims, **characterized in that** said binding material (10) as brought is formed by a viscous liquid substance.

9. Method according to claim 8, **characterized in that** said binding material (10) as brought is formed by a resin, such resin being brought with a non-elevated temperature and hardening at ambiant temperature between said steps IE and IF.

10. Method according to any one of claims 3 to 7 and claim 8 or 9, **characterized in that** said bringing of said binding material (10) is carried out in two phases, the first. phase consisting in an application of a first portion of said binding material prior to said steps IB and IG and the second phase consisting in an application of a second portion of said binding material (10) following said step IG.

11. Method according to any one of claim 3 to 7, **characterized in that** at least a part of said binding material (10) as brought is formed by a solid leaf, such leaf thereafter being at least partially melted by applying energy prior step IE, said step of hardening comprising a cooling of said binding material.

12. Method according to any one of claims 3 to 7, **characterized in that** said binding material (10) as brought is formed by two solid leaves arranged on either side of said positioning structure (46; 62; 90), such two leaves partially melted by applying energy prior step IE, said step of hardening comprising a cooling of said binding material.

13. Method of manufacture of a card according to claim 2, **characterized in that** it comprises the following subsequent and successive steps :
II) bringing first and second outer layer" (4 and 6) each formed of a solid material; IJ) bringing said layer formed by said binding material (10) between said first and second outer layers;
IK) applying energy serving to melt at least superficially said layer formed by said binding material in order to bring about adhesion of said layer to said first and second outer layers, such layer after cooling forming an intermediate layer (8; 38; 58; 88) between such first and second outer layers.

14. Method of manufacture of a card according to claim 2, **characterized in that** it comprises the following subsequent and successive steps :
III) bringing first and second outer layers, each exhibiting a surface onto which a glue film is deposited;
IIJ) bringing said layer formed by said binding material (10) between said first and second outer layers;
IIK) hardening of each glue film assuring adhesion of said first and second outer layers with said layer formed by said binding material (10).

15. Method of manufacture of a card according to any one of the preceding claims, **characterized in that** a working frame is arranged on said work surface, said binding material (10) being brought to the interior of said working frame, such working frame being permeable to said binding material when such latter is subjected to an overpressure and enabling an excess of binding material to escape during said step IE.

16. Card (31; 61; 81; 94) obtained by the method according to any one of claims 3 to 7, comprising at least one electronic element (2) and a coil (12; 42) electrically connected to said electronic element, a layer (38; 58; 88; 95) formed by a binding material (10) in which said assembly formed by said electronic element and said coil is embedded, such card being **characterized in that** it further comprises a positioning structure (46; 62; 90) located at the interior of said layer (38; 58; 88; 95) formed by said binding material (10), such positioning structure having at least one principal opening defining an internal zone within which said assembly is located, said internal zone being formed by a principal opening (48; 63) passing through said positioning structure (46; 62; 90).

17. Card according to claim 16, **characterized in that** said coil (12; 42) has two electrical connecting ends which are connected to said electronic element (2).

18. Card (31; 61; 81) according to one of claims 16 and 17, **characterized in that** it comprises first and second outer layers (4 and 6), said layer (38; 58; 88) formed by said binding material constituting an intermediate layer between said first and second outer layers, at least the major portion of the internal surface (59, 60) of each of said first and second outer layers being covered over by said binding material, such latter. assuring cohesion of such first and second outer layers with said intermediate layer.

19. Card according to any one of claims 16 to 18, **characterized in that** said positioning structure (62) is formed by a thin structure exhibiting on its lower face (64) a relief (68).

20. Card according to any one of claims 16 to 19, **characterized in that** said positioning structure (62) exhibits on its upper face (66) a relief.

21. Card according to any one of claims 16 to 18, **characterized in that** said positioning structure (90) is formed by a cellular structure.

22. Card according to any one of claims 16 to 18, **characterized in that** said positioning structure (90) is formed by expanded material.

23. Card according to any one of claims 16 to 22, **characterized in that** said positioning structure (62) has the general form of a frame.
